# EUROPEAN PATENT SPECIFICATION

(11) **EP 4 401 129 B1**
(45) Date of publication and mention of the grant of the patent: **02.09.2026**
(21) Application number: 22866236.7
(22) Date of filing: 11.07.2022
(51) Int. Cl.: H10W 40/60, H10W 40/22

(54) **RADIATOR FIXING STRUCTURE AND BOARD-LEVEL HEAT DISSIPATION APPARATUS**
HEIZKÖRPERBEFESTIGUNGSSTRUKTUR UND WÄRMEABLEITUNGSVORRICHTUNG AUF PLATTENEBENE
STRUCTURE DE FIXATION D'ÉLÉMENT RAYONNANT ET APPAREIL DE DISSIPATION DE CHALEUR À NIVEAU DE CARTE

(30) Priority: 07.09.2021 CN 202111041133
(43) Date of publication of application: 17.07.2024
(73) Proprietor: ZTE Corporation, Shenzhen, Guangdong 518057 (CN)
(72) Inventor: ZHANG, Weifeng, Shenzhen, Guangdong 518057 (CN); ZHANG, Xianming, Shenzhen, Guangdong 518057 (CN); WANG, Zhida, Shenzhen, Guangdong 518057 (CN); WU, Xijie, Shenzhen, Guangdong 518057 (CN); GUO, Yanhua, Shenzhen, Guangdong 518057 (CN)
(74) Representative: Pennacchio, Salvatore Giovanni
(86) International application number: PCT/CN2022/104895
(87) International publication number: WO 2023/035761

(56) References cited:
- CN-A- 102 709 262
- CN-A- 103 889 195
- CN-A- 113 539 996
- CN-U- 212 966 841
- CN-U- 213 403 994
- CN-U- 213 403 994
- JP-A- 2009 026 870
- JP-A- 2009 026 870
- US-A1- 2014 063 731

## Description

### Technical Field

The present disclosure relates to the field of heat dissipation technologies, and in particular, to a heat sink fixing structure and a board-level heat dissipation apparatus.

### Background

With the development of technology, the volume of an integrated circuit is continuously reduced and the function thereof is continuously improved under continuous improvement and development of the integrated circuit; however, while the function is improved, the number of semiconductor components required by the integrated circuit is increasing, and the design of the semiconductor space is becoming more and more strict and important.

Furthermore, since a plurality of semiconductor components are generally integrated on the printed integrated circuit board, and these semiconductor components generate a large amount of heat during operation, heat dissipation processing needs to be performed on the semiconductor components. Since the distance between the heat sink substrate and the integrated circuit board underlying the semiconductor components is fixed, there may be a height difference between each of the semiconductor components.

If a heat sink covers a plurality of semiconductor components, a part of the semiconductor components cannot contact a substrate of the heat sink, and a heat conductive pad is generally required to be filled between an upper surface of the semiconductor components and a bottom of the heat sink, which, however, results in increased thermal resistance, making a heat dissipation effect of the semiconductor components undesirable. If a heat sink is arranged corresponding to each semiconductor component, although heat dissipation of the semiconductor component is ensured, the number of openings needs to be increased on the printed integrated circuit board, and the more openings increase the difficulty in layout and wiring of the integrated circuit board, and also increase the probability of failure of the integrated circuit board.

Document JP2009026870A, document US2014/063731A1 and document CN213403994U provide related technical solutions.

However, how to effectively dissipate heat of a semiconductor component on a printed integrated circuit board without increasing layout and wiring difficulty of the integrated circuit board and ensure long-term reliability of the integrated circuit board is a technical problem to be solved urgently by a person skilled in the art.

### Summary

Embodiments of the present disclosure provide a heat sink fixing structure and a board-level heat dissipation apparatus, which are intended to solve the problem of how to efficiently dissipate heat of a plurality of semiconductor components on an integrated circuit board without increasing layout and wiring difficulty of the integrated circuit board, and ensure long-term reliability of the integrated circuit board.

The present invention is defined by the appended independent claims, the dependent claims constitute embodiments of the invention.

An embodiment of the present disclosure provides a board-level heat dissipation apparatus, comprising: an integrated circuit board provided with a plurality of semiconductor components; a heat sink fixing structure, the heat sink fixing structure is connected to the heat sink and the integrated circuit board, so that a heat sink in the heat sink fixing structure dissipates heat for the plurality of semiconductor components.The heat sink fixing structure comprises a support structure and a floating structure. The support structure comprises a first support member for providing support for the plurality of semiconductor components and a second member spaced apart from the first support member. The heat sink is arranged corresponding to the plurality of semiconductor components and is connected to the second support member in a floating manner by means of the floating structure.

The present disclosure provides a heat sink fixing structure comprised in a board-level heat dissipation device. A first support member supports a plurality of semiconductor components and a second support member supports a heat sink, so as to separately arrange the heat sink and the plurality of semiconductor components, so as to reduce the number of openings near the plurality of semiconductor components on an integrated circuit board, thereby reducing wiring difficulty of the integrated circuit board, and reducing stress borne by the integrated circuit board at the same time. Furthermore, the heat sink and the second support member are connected in a floating manner by means of a floating structure, so that the heat sink is adapted to semiconductor components of different heights and tolerances, thereby effectively reducing the temperature of the semiconductor components and improving the long-term reliability thereof.

### Brief Description of the Drawings

To describe the technical solutions in the embodiments of the present disclosure more clearly, the following briefly introduces the accompanying drawings required for describing the embodiments. Apparently, the accompanying drawings in the following description show merely some embodiments of the present disclosure, and a person of ordinary skill in the art may still derive other drawings from these accompanying drawings without creative efforts.
Figure 1 is a structural diagram of a first view angle of a board-level heat dissipation apparatus according to an embodiment of the present disclosure;
Figure 2 is a schematic diagram of a second view angle of a board-level heat sink according to an embodiment of the present disclosure;
Figure 3 is a structural diagram of a board-level heat dissipation apparatus according to an embodiment of the present disclosure;
Figure 4 is a partial schematic diagram of area A in figure 3;
Figure 5 is a schematic structural diagram of a first floating member according to an embodiment of the present disclosure;
Figure 6 is a structural diagram of another board-level heat dissipation apparatus according to an embodiment of the present disclosure;
Figure 7 is a schematic diagram of coordination of a floating positioning member, a heat sink and a second floating member according to an embodiment of the present disclosure;
Figure 8 is a schematic diagram showing the cooperation of another floating positioning member, a heat sink and a second floating member according to an embodiment of the present disclosure.

Reference signs: board-level heat dissipation apparatus 1;
heat sink fixing structure 100; integrated circuit board 200;
Printed Circuit Board 201; semiconductor component 202; heat conduction layer 203;
supporting structure 11; floating structure 12; heat sink 13;
first support member 111; second support member 112; connection member 113; first floating member 121; position-limiting hole 14; second floating member 122; floating positioning member 123;
connecting part 1211; deformation part 1212; abutting part 141;
first frame 1121; second frame 1122; third frame 1123; fourth frame 1124; opening 15; first positioning member 1231; second positioning member 1232; 1221 First position-limiting element; second position-limiting element 1222; elastic element 1223; containing cavity 1224; first position-limiting part 1225; second position-limiting part 1226.

### Detailed Description of the Embodiments

The following clearly and completely describes the technical solutions in the embodiments of the present disclosure with reference to the accompanying drawings in the embodiments of the present disclosure. Apparently, the embodiments to be described are merely a part rather than all of the embodiments of the present disclosure. All other embodiments obtained by a person of ordinary skill in the art based on the embodiments of the present disclosure without creative efforts shall belong to the scope of protection of the present disclosure.

It should be understood that the terminology used in this disclosure is for the purpose of describing particular embodiments only and is not intended to be limiting of the disclosure. As used in this description and the appended claims, the singular forms "a ", "an ", and "the" are intended to include the plural forms as well, unless the context clearly indicates otherwise.

It should be understood that the term "and/or" as used in this description and the appended claims refers to, and includes, any and all possible combinations of one or more of the items listed in association. It should be noted that, in this description, the terms "include", "comprise", or any other variation thereof are intended to cover a non-exclusive inclusion, so that a process, a method, an article, or a system that includes a series of elements not only includes those elements, but also includes other elements that are not explicitly listed, or further includes inherent elements of the process, the method, the article, or the system. An element limited by "including a...... " does not exclude that there are other same elements in the process, method, article, or system that includes the element, unless there are more limitations.

Some embodiments of the present disclosure will be described in detail below with reference to the accompanying drawings. Without conflict, the following embodiments and features in the embodiments may be combined with each other.

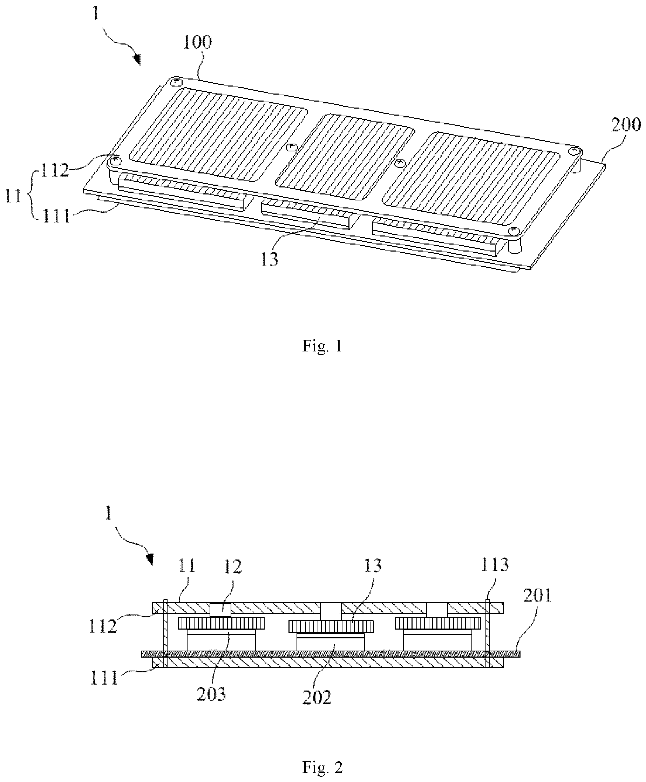

Please refer to figures 1 and 2, a board-level heat sink 1 according to an embodiment of the present disclosure includes a heat sink fixing structure 100 and an integrated circuit board 200.

Specifically, the heat sink fixing structure 100 comprises a support structure 11 and a floating structure 12 for connecting the heat sink 13 and the integrated circuit board 200. The support structure 11 is used for providing support for the integrated circuit board 200 and the heat sink 13; the integrated circuit board 200 is provided with a plurality of semiconductor components 202; the heat sink 13 is arranged corresponding to the semiconductor components 202, and is connected to the support structure 11 in a floating manner via the floating structure 12, so that the heat sink 13 can adapt to the semiconductor components 202 of different heights.

The support structure 11 comprises a first support 111 and a second support 112. The first support 111 and the second support 112 are connected and spaced apart. The first support 111 is used for supporting the integrated circuit board 200, and the second support 112 is connected to the heat sink 13 in a floating manner via the floating structure 12, when the heat sink 13 performs heat dissipation processing on the semiconductor components 202 of different heights, the heat sink 13 can move in the first direction through the floating structure 12, thereby adapting the semiconductor components 202 at different heights, and at the same time, providing an elastic force via the floating structure 12, by bringing the heat sink 13 into close contact with the semiconductor component 202, the heat dissipation effect is ensured. The first direction is a thickness direction of the heat sink 13.

The integrated circuit board 200 comprises a printed circuit board 201 and a semiconductor component 202 connected to the printed circuit board 201, and the heat sink 13 is arranged corresponding to the semiconductor component 202. The printed circuit board 201 is provided with a plurality of through-holes, and a connection member 113 is provided corresponding to the through-holes. The connection member 113 is connected to the first support member 111 and the second support member 112 respectively through the through-holes. The printed circuit board 201 is disposed between the first support member 111 and the second support member 112, and limits the position of the integrated circuit board 200 through the through-holes. By providing the first support 111 and the integrated circuit board 200 separately, the stress of the integrated circuit board 200 is reduced, and the integrated circuit board 200 is prevented from being deformed due to an external force, so as to prolong the service life of the integrated circuit board 200.

In some embodiments, a thermally conductive layer 203 is disposed between the heat sink 13 and the semiconductor component 202, a first face of the thermally conductive layer 203 is in contact with the heat sink 13, and a second face of the thermally conductive layer 203, opposite to the first face, is in contact with the semiconductor component 202. The heat conduction layer 203 is used to transfer the heat generated by the semiconductor component 202 to the heat sink 13 so as to dissipate the heat of the semiconductor component 202 through the heat sink 13. The thermally conductive layer 203 includes, but is not limited to, thermally conductive silica gel.

By means of the floating structure 12, the heat sink 13 is connected to the second support member 112 in a floating manner, so that the heat sink 13 adapts to the semiconductor components 202 of different heights, thereby reducing the thickness of the heat conduction layer 203, and reducing the thermal resistance of the heat generated by the semiconductor components 202 in the process of being transferred to the heat sink 13, i.e. avoiding the case where the heat conduction layer 203 is too thick to hinder the heat transfer, and improving the heat dissipation effect of the semiconductor components 202.

It can be understood that, the heat sink fixing device 100 may be connected to a plurality of heat sinks 13, and the plurality of heat sinks 13 may be arranged on the second support member 112 in series or in parallel, so as to simultaneously dissipate heat for the plurality of semiconductor components 202 on the first support member 111. The heat sink 13 includes, but is not limited to, a liquid-cooled heat sink, an air-cooled heat sink, and the like. The number and arrangement manner of the heat sinks 13 may be selected according to specific usage scenarios, and the embodiments of the present disclosure are not limited thereto.

It can be understood that the support structure 11 may comprise different materials, such as metal, plastic, and ceramic, which can be selected according to specific usage scenarios, and the embodiments of the present disclosure are not limited thereto.

The first support member 111 supports the integrated circuit board 200, the second support member 112 supports the heat sink 13, and the heat sink 13 and the integrated circuit board 200 are arranged separately, so as to reduce the number of openings on the integrated circuit board 200, thereby reducing the wiring difficulty of the integrated circuit board 200, reducing the stress borne by the integrated circuit board 200 at the same time, and ensuring long-term reliability of the integrated circuit board 200. Furthermore, the heat sink 13 and the second support member 112 are connected in a floating manner by using the floating structure 12, so that the heat sink 13 is adapted to the semiconductor components 202 of different heights while the heat dissipation effect is ensured.

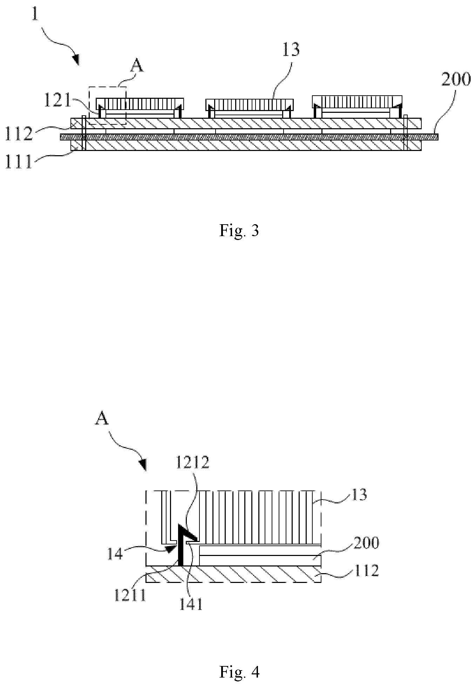

Referring to figures 3 and 4, in some embodiments, the second support member 112 is disposed between the heat sink 13 and the first support member 111, the floating structure 12 includes at least two first floating members 121, one of the heat sink 13 and the second support member 112 is provided with a position limiting hole 14, and the other of the heat sink 13 and the second support member 112 is connected to the first floating member 121. The position-limiting hole 14 and the first floating member 121 form a position-limiting fit, so that the second support member 112 and the heat sink 13 are in a floating fit through the position-limiting hole 14 and the first floating member 121.

For example, when the heat sink 13 is provided with the position-limiting hole 14, the second support member 112 and the first floating member 121 are connected. When the second supporting member 112 is provided with the position-limiting hole 14, the heat sink 13 and the first floating member 121 are connected.

It should be understood that, in order to ensure that the heat sink 13 contacts the semiconductor component 202 to dissipate heat, the spacing between the first support 111 and the second support 112 is less than the height of the semiconductor component 202.

By disposing the second support member 112 between the heat sink 13 and the first support member 111, the case that the heat sink 13 is unsmooth due to being blocked by an external object is avoided, thereby improving the heat dissipation efficiency of the heat sink 13. The heat sink 13 can float with respect to the semiconductor component 202 through the first floating member 121 and the stop hole 14 so as to adapt to the semiconductor components 202 of different heights.

In some embodiments, as shown in figure 4, the first floating member 121 comprises a connecting part 1211 and a deformation part 1212. The deformation part 1212 and the connecting part 1211 are disposed at an angle, one end of the connecting part 1211 is connected to one of the second support member 112 and the heat sink 13, and the other end of the connecting part 1211 penetrates through the position-limiting hole 14 and is connected to one end of the deformation part 1212.

Specifically, an example in which the heat sink 13 is provided with a position-limiting hole 14, and the second support member 112 is connected to the first floating member 121 is described.

As shown in figure 4, an abutting part 141 is provided on the peripheral side of the position limiting hole 14, the other end of the deformation part 1212 abuts against the abutting part 141, and the deformation part 1212 is limited by the abutting part 141. When the height of the semiconductor component 202 is too high, the heat sink 13 moves in a direction away from the second support 112, and at the same time, the included angle between the connecting part 1211 of the first floating member 121 and the deformation part 1212 is increased, and the heat sink 13 is tightly pressed against the semiconductor component 202 by the elastic force provided by the first floating member 121. When the height of the semiconductor component 202 is too low, the heat sink 13 moves toward the second support 112, and at the same time, the angle formed between the connecting part 1211 of the first floating member 121 and the deformation part 1212 is reduced, and the heat sink 13 tightly contacts the semiconductor component 202 by the elastic force provided by the first floating member 121.

By means of the change of the included angle between the connecting part 1121 and the deformation part 1212, the heat sink 13 is adapted to the semiconductor components 202 with different heights, so as to ensure the heat dissipation effect of the heat sink 13.

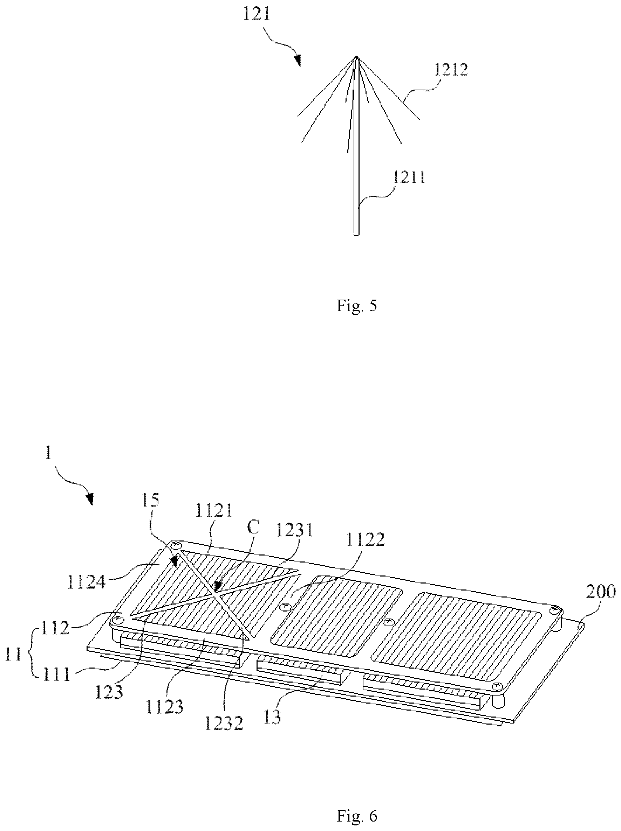

Please refer to figure 5, in some embodiments, there are a plurality of first floating members 121, and the plurality of first floating members 121 are annularly arranged, so that the connection portion 1211 is correspondingly provided with a plurality of deformation part 1212. Thus, when the heat sink 13 is acted by an external force, the plurality of deformation part 1212 provide an elastic force at the same time, so as to prevent an assembly imbalance caused by the force imbalance between the heat sink 13 and the semiconductor component 202.

In some embodiments, the first floating members 121 are disposed on at least two opposite sides of the heat sink 13, and at least two first floating members 121 are disposed on each side, so as to prevent assembly unbalance caused by force imbalance between the heat sink 13 and the semiconductor component 202.

By means of the deformation part 1212 and the connection portion 1211 which are arranged at an included angle, the heat sink 13 can be floated by the change of the included angle. During assembly, the deformation part 1212 of the first floating member 121 is directly pressed into the position limiting hole 14, which facilitates assembly and disassembly of the heat sink 13 and the second support member 112. Furthermore, the use of screws is avoided, so that no stress concentration exists in the second support member 112, thereby preventing the second support member 112 from deforming due to supporting stress, and prolonging the service life of the second support member 112.

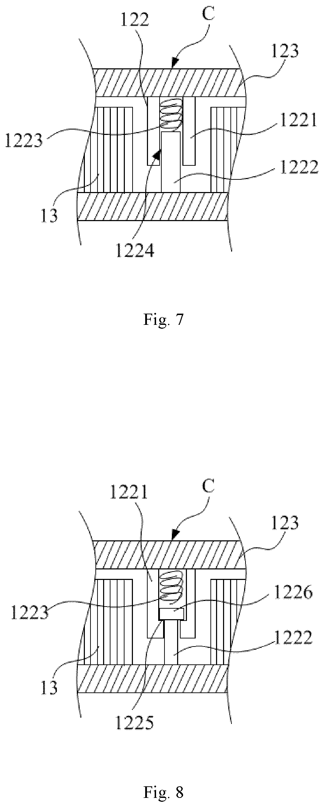

Please refer to figures 6 and 7, in some embodiments, the heat sink 13 is disposed between the first support 111 and the second support 112, the floating structure 12 comprises a second floating member 122 and a floating positioning member 123, in which the floating positioning member 123 is connected to the second support member 112, one end of the second floating member 122 is connected to the floating positioning member 123, and the other end of the second floating member 122 is connected to the heat sink 13, so as to float-fit the heat sink 13 with the second support 112 through the second floating member 122.

The heat sink 13 is disposed between the first support 111 and the second support 112, and the second floating member 122 is fixed by the floating positioning member 123 connected to the second support 112, thereby not only reducing the number of the second floating members 122, but also distributing the pressure transferred from the second floating member 122 to the second support 112 by the floating positioning member 123, so that the whole structure of the heat sink fixing apparatus 100 is more firm.

Specifically, as shown in figure 6, the second support member 112 comprises a first side frame 1121, a second side frame 1122, a third side frame 1123 and a fourth side frame 1124. The first frame 1121 is connected to the second frame 1122 and the fourth frame 1124, the second frame 1122 is spaced apart from the fourth frame 1124, the third frame 1123 is connected to the second frame 1122 and the fourth frame 1124, and the third frame 1123 is spaced apart from the first frame 1121. The first frame 1121, the second frame 1122, the third frame 1123, and the fourth frame 1124 form an opening 15, and the heat sink 13 is disposed corresponding to the opening 15.

The floating position piece 123 includes a first position piece 1231 and a second position piece 1232, and the first position piece 1231 intersects with the second position piece 1232. Two opposite ends of the first positioning member 1231 are respectively connected to at least two of the first frame 1121, the second frame 1122, the third frame 1123, and the fourth frame 1124, two ends of the second positioning member 1232 are respectively connected to at least two of the first frame 1121, the second frame 1122, the third frame 1123, and the fourth frame 1124, and the second floating member 122 is disposed at an intersection point of the first positioning member 1231 and the second positioning member 1232.

Exemplarily, as shown in figures 6 and 7, one end of the first positioning member 1231 is connected to a connection portion of the first frame 1121 and the second frame 1122, the other end of the first positioning member 1231 is connected to the joint of the third frame 1123 and the fourth frame 1124, and one end of the second positioning member 1232 is connected to the joint of the second frame 1122 and the third frame 1123, the other end of the second positioning member 1232 is connected to the connection between the first frame 1121 and the fourth frame 1124, the first positioning member 1231 intersects the second positioning member 1232 at point C, the second floating member 122 is disposed at point C.

It should be understood that, the first positioning member 1231 and the second positioning member 1232 may be provided integrally with the second support member 112, or may be provided separately from the second support member 112, which is not limited in the embodiment of the present disclosure.

By providing the opening 15, the contact area between the heat sink 13 and the outside air is increased, which facilitates air circulation of the heat sink 13, thereby improving the heat dissipation efficiency. By disposing the second floating member 122 at the intersection point of the first positioning member 1231 and the second positioning member 1232, the pressure transferred from the second floating member 122 is distributed evenly to the second support member 112, and the second support member 112 is divided into a plurality of triangles by the intersection design of the first positioning member 1231 and the second positioning member 1232, so that the second support member 112 is more firm, and the service life of the second support member 112 is prolonged.

In some embodiments, as shown in figure 6, the intersecting point C of the first positioning member 1231 and the second positioning member 1232 is located in the central area of the heat sink 13 projected in the first direction, that is, the second floating member 122 is arranged in the central area of the heat sink 13 projected in the first direction. By disposing the second floating member 122 in the central region of the heat sink 13, a case in which assembling of the heat sink 13 and the semiconductor component 202 is unbalanced is avoided, and the opposite surfaces of the heat sink 13 and the semiconductor component 202 can be closely attached, thereby improving the heat dissipation efficiency.

In some embodiments, as shown in figure 7, the second floating member 122 comprises a first position-limiting element 1221, a second position-limiting element 1222 and an elastic element 1223. The first position-limiting element 1221 is connected to one of the floating positioning member 123 and the heat sink 13, the second position-limiting element 1222 is connected to the other of the floating positioning member 123 and the heat sink 13, and forms a position-limiting fit with the first position-limiting element 1221, and the elastic element 1223 is disposed between the first position-limiting element 1221 and the second position-limiting element 1222, so that the heat sink 13 and the second support 112 are enabled to be in a floating fit through the elastic element 1223. The elastic element 1223 includes, but is not limited to, a spring, an elastic piece, and the like.

Exemplarily, the first position-limiting element 1221 is formed with an accommodating cavity 1224 having an opening, one end of the elastic element 1223 and the second position-limiting element 1222 is accommodated in the accommodating cavity 1224, and the other end of the second position-limiting element 1222 is connected to one of the second support member 112 and the heat sink 13. The elastic force provided by the elastic element 1223 enables one end of the second position-limiting element 1222 to move within the accommodating cavity 1224.

It should be understood that, in order to ensure no shaking between the first position-limiting element 1221 and the second position-limiting element 1222, the size and shape of the receiving chamber 1224 are adapted to the size and shape of the second position-limiting element 1222.

It should be understood that the size and shape of the second position-limiting element 1222 can be selected according to the practical application, and the embodiment of the present disclosure is not limited thereto.

A specific manner of forming a position-position-limiting fit between the first position-limiting element 1221 and the second position-limiting element 1222 is not limited herein, and one end of the elastic element 1223 may be connected to one side of the accommodating cavity 1224 away from the opening, and the other end of the elastic element 1223 is connected to the second position-limiting element 1222, so that the position-position-limiting fit between the first position-limiting element 1221 and the second position-limiting element 1222 is achieved by an elastic force of the elastic element 1223. Please refer to figure 8, it is also possible that the first position-limiting element 1221 is provided with a first position-limiting element 1225, the second position-limiting element 1222 is provided with a second position-limiting element 1226, and the first position-limiting element 1225 and the second position-limiting element 1226 form a limit fit.

By means of the limit fitting between the first position-limiting element 1221 and the second position-limiting element 1222, the heat sink 13 is enabled to move steadily under the action of an external force, thereby further avoiding the situation of assembly unbalance between the heat sink 13 and the semiconductor component 202. The first position-limiting element 1221, the second position-limiting element 1222, and the elastic element 1223 are easy to be assembled and disassembled, and the heat sink 13 and the second support member 112 are prevented from being perforated, the floating coordination between the heat sink 13 and the second support member 112 can be achieved by directly using the first position-limiting element 1221, the second position-limiting element 1222, and the elastic element 1223, thus, no stress concentration exists on the heat sink 13 and the second support member 112, and the service life of the heat sink 13 and the second support member 112 is prolonged.

In the description of the present disclosure, the terms "installation", "connection", "connection", "fixing" and the like should be understood broadly, for example, "connection" may be a fixed connection, may also be a detachable connection, or may be an integral connection; may also be direct connections or indirect connections via intervening structures. The specific meanings of the above terms in the present disclosure can be understood by those skilled in the art according to specific situations. In the description of the description, the description of the terms "one embodiment", "some embodiments", "specific embodiment", and the like means that a particular feature, structure, material, or characteristic described in connection with the embodiment or example is included in at least one embodiment or example of the present disclosure. Thus, the appearances of the phrases in various places throughout this description are not necessarily referring to the same embodiment or example of the present disclosure. Furthermore, the particular features, structures, materials, or characteristics described may be combined in any suitable manner in one or more embodiments or examples.

The serial numbers of the embodiments of the present disclosure are only for description, and do not represent the preference of the embodiments. Therefore, the scope of protection of the present disclosure shall be subject to the scope of protection of the claims.

## Claims

1. A board-level heat dissipation apparatus, comprising:
an integrated circuit board (200) provided with a plurality of semiconductor components (202);
a heat sink fixing structure (100), wherein the heat sink fixing structure (100) is connected to the integrated circuit board (200), so that a heat sink (13) in the heat sink fixing structure (100) dissipates heat for the plurality of semiconductor components (202);
wherein the heat sink fixing structure (100) comprises:
a support structure (11) and a floating structure (12);
the support structure (11) comprises a first support member (111) for supporting the plurality of semiconductor components (202) and a second support member (112) spaced apart from the first support member (111);
wherein a heat sink (13) is provided corresponding to the plurality of semiconductor components (202) and is connected to the second support member (112) in a floating manner by means of the floating structure (12).

2. The board-level heat dissipation apparatus according to claim 1, wherein the heat sink fixing structure (100) is arranged so that:
the second support member (112) is disposed between the heat sink (13) and the first support member (111);
the floating structure (12) comprises at least two first floating members (121);
one of the heat sink (13) and the second support member (112) is provided with a position-limiting hole (14), the other is connected to the first floating members (121), and the first floating members (121) make the heat sink (13) and the second support member (112) floating fitted through the position-limiting hole (14).

3. The board-level heat dissipation apparatus according to claim 2, wherein the heat sink fixing structure (100) is arranged so that:
the first floating member (121) comprises a connecting part (1211) and a deformation part (1212) that is disposed at an angle with respect to the connecting part (1211);
one end of the connecting part (1211) is connected to one of the second support member (112) and the heat sink (13), and the other end of the connecting part (1211) penetrates through the position-limiting hole (14) and is connected to one end of the deformation part (1212).

4. The board-level heat dissipation apparatus according to claim 3, wherein the heat sink fixing structure (100) is arranged so that:
an abutting part (141) is provided on the periphery of the position-limiting hole (14);
the other end of the deformation part (1212) abuts against the abutting part (141) and forms a position-limiting fit with the abutting part (141).

5. The board-level heat dissipation apparatus according to claim 3, wherein the at least two first floating members (121) are annularly arranged.

6. The board-level heat dissipation apparatus according to claim 1, wherein the heat sink fixing structure (100) is arranged so that:
the heat sink (13) is disposed between the second support member (112) and the first support member (111);
the floating structure (12) comprises a floating positioning member (123) and a second floating member (122);
the floating positioning member (123) is connected to the second support member (112); one end of the second floating member (122) is connected to the floating positioning member (123); the other end of the second floating member (122) is connected to the heat sink (13); and the heat sink (13) and the second support member (112) are in a floating fit by means of the second floating member (122).

7. The board-level heat dissipation apparatus according to claim 6, wherein:
the second support member (112) comprises a first frame (1121), a second frame (1122) connected with the first frame (1121), a third frame (1123) connected with the second frame (1122) and spaced apart from the first frame (1121), and a fourth frame (1124) connected with the third frame (1123) and the first frame (1121) and spaced apart from the second frame (1122);
the first frame (1121), the second frame (1122), the third frame (1123), and the fourth frame (1124) form an opening (15), and the heat sink (13) is arranged corresponding to the opening (15).

8. The board-level heat dissipation apparatus according to claim 6 or 7, wherein:
the second floating member (122) is arranged in a central region of the heat sink (13) projected in a first direction, and the first direction is a thickness direction of the heat sink (13).

9. The board-level heat dissipation apparatus according to claim 8, wherein:
the second floating member (122) comprises a first position-limiting element (1221), a second position-limiting element (1222) and an elastic element (1223);
the first position-limiting element (1221) is connected to one of the floating positioning member (123) and the heat sink (13);
the second position-limiting element (1222) is connected to the other of the floating positioning member (123) and the heat sink (13), and forms a position-limiting fit with the first position-limiting element (1221);
the elastic element (1223) is disposed between the first position-limiting element (1221) and the second position-limiting element (1222) , so that the heat sink (13) and the second support member (112) are in floating fit.

10. The board-level heat dissipation apparatus according to claim 1, wherein the heat sink fixing structure (100) is connected to a plurality of heat sinks (13), and the plurality of heat sinks (13) are arranged on the second support member (112) in series or in parallel.

11. The board-level heat dissipation apparatus according to claim 1, wherein the heat sink (13) is movable in a first direction through the floating structure (12), so as to adapt the plurality of semiconductor components (202) at different heights.

12. The board-level heat dissipation apparatus according to claim 1, wherein the support structure (11) comprises one of the following material: metal, plastic, and ceramic.

## Patentansprüche

1. Wärmeableitungsvorrichtung auf Platinenebene, umfassend:
eine integrierte Leiterplatte (200), die mit einer Vielzahl von Halbleiterkomponenten (202) versehen ist;
eine Kühlkörperbefestigungsstruktur (100), wobei die Kühlkörperbefestigungsstruktur (100) mit der integrierten Leiterplatte (200) verbunden ist, sodass ein Kühlkörper (13) in der Kühlkörperbefestigungsstruktur (100) Wärme für die Vielzahl von Halbleiterkomponenten (202) ableitet;
wobei die Kühlkörperbefestigungsstruktur (100) umfasst:
eine Stützstruktur (11) und eine schwimmende Struktur (12);
die Stützstruktur (11) umfasst ein erstes Stützelement (111) zum Stützen der Vielzahl von Halbleiterkomponenten (202) und ein zweites Stützelement (112), das von dem ersten Stützelement (111) beabstandet ist;
wobei ein Kühlkörper (13) entsprechend der Vielzahl von Halbleiterkomponenten (202) vorgesehen ist und mit dem zweiten Stützelement (112) mittels der schwimmenden Struktur (12) schwimmend verbunden ist.

2. Wärmeableitungsvorrichtung auf Platinenebene nach Anspruch 1, wobei die Kühlkörperbefestigungsstruktur (100) so angeordnet ist, dass:
das zweite Stützelement (112) zwischen dem Kühlkörper (13) und dem ersten Stützelement (111) angeordnet ist;
die schwimmende Struktur (12) mindestens zwei erste schwimmende Elemente (121) umfasst;
einer von dem Kühlkörper (13) und dem zweiten Stützelement (112) mit einem Positionsbegrenzungsloch (14) versehen ist, der andere mit den ersten schwimmenden Elementen (121) verbunden ist, und die ersten schwimmenden Elemente (121) bewirken, dass der Kühlkörper (13) und das zweite Stützelement (112) durch das Positionsbegrenzungsloch (14) schwimmend eingepasst sind.

3. Wärmeableitungsvorrichtung auf Platinenebene nach Anspruch 2, wobei die Kühlkörperbefestigungsstruktur (100) so angeordnet ist, dass:
das erste schwimmende Element (121) einen Verbindungsteil (1211) und einen Verformungsteil (1212) umfasst, der in einem Winkel in Bezug auf den Verbindungsteil (1211) angeordnet ist;
ein Ende des Verbindungsteils (1211) mit einem von dem zweiten Stützelement (112) und dem Kühlkörper (13) verbunden ist, und das andere Ende des Verbindungsteils (1211) das Positionsbegrenzungsloch (14) durchdringt und mit einem Ende des Verformungsteils (1212) verbunden ist.

4. Wärmeableitungsvorrichtung auf Platinenebene nach Anspruch 3, wobei die Kühlkörperbefestigungsstruktur (100) so angeordnet ist, dass:
ein Anlageteil (141) am Umfang des Positionsbegrenzungslochs (14) vorgesehen ist;
das andere Ende des Verformungsteils (1212) an dem Anlageteil (141) anliegt und eine Positionsbegrenzungspassung mit dem Anlageteil (141) bildet.

5. Wärmeableitungsvorrichtung auf Platinenebene nach Anspruch 3, wobei die mindestens zwei ersten schwimmenden Elemente (121) ringförmig angeordnet sind.

6. Wärmeableitungsvorrichtung auf Platinenebene nach Anspruch 1, wobei die Kühlkörperbefestigungsstruktur (100) so angeordnet ist, dass:
der Kühlkörper (13) zwischen dem zweiten Stützelement (112) und dem ersten Stützelement (111) angeordnet ist;
die schwimmende Struktur (12) ein schwimmendes Positionierungselement (123) und ein zweites schwimmendes Element (122) umfasst;
das schwimmende Positionierungselement (123) mit dem zweiten Stützelement (112) verbunden ist; ein Ende des zweiten schwimmenden Elements (122) mit dem schwimmenden Positionierungselement (123) verbunden ist; das andere Ende des zweiten schwimmenden Elements (122) mit dem Kühlkörper (13) verbunden ist; und der Kühlkörper (13) und das zweite Stützelement (112) mittels des zweiten schwimmenden Elements (122) in einer schwimmenden Passung stehen.

7. Wärmeableitungsvorrichtung auf Platinenebene nach Anspruch 6, wobei:
das zweite Stützelement (112) einen ersten Rahmen (1121), einen mit dem ersten Rahmen (1121) verbundenen zweiten Rahmen (1122), einen mit dem zweiten Rahmen (1122) verbundenen und von dem ersten Rahmen (1121) beabstandeten dritten Rahmen (1123) sowie einen mit dem dritten Rahmen (1123) und dem ersten Rahmen (1121) verbundenen und von dem zweiten Rahmen (1122) beabstandeten vierten Rahmen (1124) umfasst;
der erste Rahmen (1121), der zweite Rahmen (1122), der dritte Rahmen (1123) und der vierte Rahmen (1124) eine Öffnung (15) bilden und der Kühlkörper (13) entsprechend der Öffnung (15) angeordnet ist.

8. Wärmeableitungsvorrichtung auf Platinenebene nach Anspruch 6 oder 7, wobei:
das zweite schwimmende Element (122) in einem zentralen Bereich des Kühlkörpers (13) angeordnet ist, der in einer ersten Richtung projiziert wird, und die erste Richtung eine Dickenrichtung des Kühlkörpers (13) ist.

9. Wärmeableitungsvorrichtung auf Platinenebene nach Anspruch 8, wobei:
das zweite schwimmende Element (122) ein erstes Positionsbegrenzungselement (1221), ein zweites Positionsbegrenzungselement (1222) und ein elastisches Element (1223) umfasst;
das erste Positionsbegrenzungselement (1221) mit einem von dem schwimmenden Positionierungselement (123) und dem Kühlkörper (13) verbunden ist;
das zweite Positionsbegrenzungselement (1222) mit dem anderen von dem schwimmenden Positionierungselement (123) und dem Kühlkörper (13) verbunden ist und eine Positionsbegrenzungspassung mit dem ersten Positionsbegrenzungselement (1221) bildet;
das elastische Element (1223) zwischen dem ersten Positionsbegrenzungselement (1221) und dem zweiten Positionsbegrenzungselement (1222) angeordnet ist, sodass der Kühlkörper (13) und das zweite Stützelement (112) in einer schwimmenden Passung stehen.

10. Wärmeableitungsvorrichtung auf Platinenebene nach Anspruch 1, wobei die Kühlkörperbefestigungsstruktur (100) mit einer Vielzahl von Kühlkörpern (13) verbunden ist und die Vielzahl von Kühlkörpern (13) an dem zweiten Stützelement (112) in Reihe oder parallel angeordnet ist.

11. Wärmeableitungsvorrichtung auf Platinenebene nach Anspruch 1, wobei der Kühlkörper (13) durch die schwimmende Struktur (12) in einer ersten Richtung beweglich ist, um sich an die Vielzahl von Halbleiterkomponenten (202) in unterschiedlichen Höhen anzupassen.

12. Wärmeableitungsvorrichtung auf Platinenebene nach Anspruch 1, wobei die Stützstruktur (11) eines der folgenden Materialien umfasst: Metall, Kunststoff und Keramik.

## Revendications

1. Appareil de dissipation thermique au niveau de la carte, comprenant :
une carte de circuit intégré (200) munie d'une pluralité de composants semi-conducteurs (202) ;
une structure de fixation de dissipateur thermique (100), dans lequel la structure de fixation de dissipateur thermique (100) est reliée à la carte de circuit intégré (200), de sorte qu'un dissipateur thermique (13) dans la structure de fixation de dissipateur thermique (100) dissipe la chaleur pour la pluralité de composants semi-conducteurs (202) ;
dans lequel la structure de fixation de dissipateur thermique (100) comprend :
une structure de support (11) et une structure flottante (12) ;
la structure de support (11) comprend un premier élément de support (111) pour supporter la pluralité de composants semi-conducteurs (202) et un deuxième élément de support (112) espacé du premier élément de support (111) ;
dans lequel un dissipateur thermique (13) est prévu correspondant à la pluralité de composants semi-conducteurs (202) et est relié au deuxième élément de support (112) de manière flottante au moyen de la structure flottante (12).

2. Appareil de dissipation thermique au niveau de la carte selon la revendication 1, dans lequel la structure de fixation du dissipateur thermique (100) est disposée de telle sorte que :
le deuxième élément de support (112) est disposé entre le dissipateur thermique (13) et le premier élément de support (111) ;
la structure flottante (12) comprend au moins deux premiers éléments flottants (121) ;
l'un du dissipateur thermique (13) et du deuxième élément de support (112) est pourvu d'un trou de limitation de position (14), l'autre est relié aux premiers éléments flottants (121), et les premiers éléments flottants (121) permettent au dissipateur thermique (13) et au deuxième élément de support (112) d'être montés de manière flottante à travers le trou de limitation de position (14).

3. Appareil de dissipation thermique au niveau de la carte selon la revendication 2, dans lequel la structure de fixation du dissipateur thermique (100) est disposée de telle sorte que :
le premier élément flottant (121) comprend une partie de liaison (1211) et une partie de déformation (1212) qui est disposée à un angle par rapport à la partie de liaison (1211) ;
une extrémité de la partie de liaison (1211) est reliée à l'un du deuxième élément de support (112) et du dissipateur thermique (13), et l'autre extrémité de la partie de liaison (1211) pénètre à travers le trou de limitation de position (14) et est reliée à une extrémité de la partie de déformation (1212).

4. Appareil de dissipation thermique au niveau de la carte selon la revendication 3, dans lequel la structure de fixation du dissipateur thermique (100) est disposée de telle sorte que :
une partie de butée (141) est prévue sur la périphérie du trou de limitation de position (14) ;
l'autre extrémité de la partie de déformation (1212) vient en butée contre la partie de butée (141) et forme un ajustement de limitation de position avec la partie de butée (141).

5. Appareil de dissipation thermique au niveau de la carte selon la revendication 3, dans lequel les au moins deux premiers éléments flottants (121) sont disposés de manière annulaire.

6. Appareil de dissipation thermique au niveau de la carte selon la revendication 1, dans lequel la structure de fixation du dissipateur thermique (100) est disposée de telle sorte que :
le dissipateur thermique (13) est disposé entre le deuxième élément de support (112) et le premier élément de support (111) ;
la structure flottante (12) comprend un élément de positionnement flottant (123) et un deuxième élément flottant (122) ;
l'élément de positionnement flottant (123) est relié au deuxième élément de support (112) ; une extrémité du deuxième élément flottant (122) est reliée à l'élément de positionnement flottant (123) ; l'autre extrémité du deuxième élément flottant (122) est reliée au dissipateur thermique (13) ; et le dissipateur thermique (13) et le deuxième élément de support (112) sont dans un montage flottant au moyen du deuxième élément flottant (122).

7. Appareil de dissipation thermique au niveau de la carte selon la revendication 6, dans lequel :
le deuxième élément de support (112) comprend un premier cadre (1121), un deuxième cadre (1122) relié au premier cadre (1121), un troisième cadre (1123) relié au deuxième cadre (1122) et espacé du premier cadre (1121), et un quatrième cadre (1124) relié au troisième cadre (1123) et au premier cadre (1121) et espacé du deuxième cadre (1122) ;
le premier cadre (1121), le deuxième cadre (1122), le troisième cadre (1123) et le quatrième cadre (1124) forment une ouverture (15), et le dissipateur thermique (13) est disposé de manière à correspondre à l'ouverture (15).

8. Appareil de dissipation thermique au niveau de la carte selon la revendication 6 ou 7, dans lequel :
le deuxième élément flottant (122) est disposé dans une région centrale du dissipateur thermique (13) faisant saillie dans une première direction, et la première direction est une direction d'épaisseur du dissipateur thermique (13).

9. Appareil de dissipation thermique au niveau de la carte selon la revendication 8, dans lequel :
le deuxième élément flottant (122) comprend un premier élément de limitation de position (1221), un deuxième élément de limitation de position (1222) et un élément élastique (1223) ;
le premier élément de limitation de position (1221) est relié à l'un de l'élément de positionnement flottant (123) et du dissipateur thermique (13) ;
le deuxième élément de limitation de position (1222) est relié à l'autre élément parmi l'élément de positionnement flottant (123) et le dissipateur thermique (13), et forme un ajustement de limitation de position avec le premier élément de limitation de position (1221) ;
l'élément élastique (1223) est disposé entre le premier élément de limitation de position (1221) et le deuxième élément de limitation de position (1222), de sorte que le dissipateur thermique (13) et le deuxième élément de support (112) sont en montage flottant.

10. Appareil de dissipation thermique au niveau de la carte selon la revendication 1, dans lequel la structure de fixation de dissipateur thermique (100) est reliée à une pluralité de dissipateurs thermiques (13), et la pluralité de dissipateurs thermiques (13) sont disposés sur le deuxième élément de support (112) en série ou en parallèle.

11. Appareil de dissipation thermique au niveau de la carte selon la revendication 1, dans lequel le dissipateur thermique (13) est mobile dans une première direction à travers la structure flottante (12), de manière à adapter la pluralité de composants semi-conducteurs (202) à différentes hauteurs.

12. Appareil de dissipation thermique au niveau de la carte selon la revendication 1, dans lequel la structure de support (11) comprend l'un des matériaux suivants : le métal, le plastique et la céramique.
